# EUROPEAN PATENT SPECIFICATION

(11) **EP 1 734 571 B1**
(45) Date of publication and mention of the grant of the patent: **20.08.2008**
(21) Application number: 05291261.5
(22) Date of filing: 10.06.2005
(51) Int. Cl.: H01L 21/66, H01L 23/544

(54) **Thermal processing equipment calibration method**
Kalibrierverfahren für Apparaturen zur thermischen Behandlung
Procédé d'étalonnage pour système de traitement thermique

(43) Date of publication of application: 20.12.2006
(73) Proprietor: S.O.I.TEC Silicon on Insulator Technologies S.A., Bernin 38926 Crolles Cédex (FR)
(72) Inventor: Bras, Marlene, 38000 Grenoble (FR)
(74) Representative: Grünecker, Kinkeldey, Stockmair & Schwanhäusser Anwaltssozietät

(56) References cited:
- US-A1- 2004 151 483
- US-B1- 6 200 023
- GELPEY J C ET AL: "UNIFORMITY CHARACTERIZATION OF AN RTP SYSTEM" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, 1987, pages 612-617, XP000885199 ISSN: 0168-583X

## Description

This invention relates to a method for calibrating thermal processing equipment comprising a heating device and which is used for a heat treatment of a multilayer substrate. The invention furthermore relates to a calibration test substrate and a method for creating the calibration test substrate.

Thermal processing equipment is usually used for thermally treating wafers in a hydrogen, argon or oxygen atmosphere, in order to, for example, form an oxide layer or to smooth the surface of a wafer. In order to achieve uniform temperature across the wafers, the equipment needs to be calibrated. For this purpose temperature sensors are positioned below the wafer which is usually positioned horizontally in a furnace chamber. These sensors measure the local temperature of the wafer and are connected to a control system which allows to adapt locally the heat provided to the wafer.

A typical method for calibrating such equipment when treating bulk silicon wafers consists of applying a rapid thermal oxidation to form about 100Å of SiO₂ with an offset set to "0" for all probes. Then an oxide thickness profile across the wafer is measured revealing the thermal non-uniformities within the chamber, as actually the oxidation thickness is dependent of the temperature. Afterwards the offset values are adapted to correct for temperature non-uniformity and the process is repeated until an oxide layer with a flat or even thickness profile is formed on the wafer and which corresponds to a uniform temperature within the chamber.

Such a direct calibration of thermal processing equipment is, however, not applicable to multilayer type substrates, like, for example silicon on insulator (SOI) wafers. US patent US 6,853,802 exposes the problem that SOI-like structures are presenting a non-homogenous structure on the edge thereby providing local differences in the heat absorption coefficients. Thus, when treating the substrate in the thermal processing equipment, this local difference has to be taken into account, which is typically done by reducing the temperature applied on the edge of the wafer in comparison to the treatment applied to the bulk wafers. By doing so it becomes possible to minimize slip lines and wafer deformation, which would otherwise occur. US 6,853,802 proposes to adapt the thermal treatment by determining the heat absorption coefficient of the structure to be treated and by adapting the power to the heating lamps of the equipment accordingly. This method does, however, have the problem that the calibration is not achieved in a direct way and that in fact a correlation between the heat absorption coefficients and the equipment parameters needs to be established.

A second way of calibrating the equipment is to perform calibration experiments on actual SOI wafers to sequentially adapt the heating power so that slip lines and wafer deformation become minimized. For example, one could start from equipment that has been calibrated for bulk silicon wafers, like described above, and then adapt especially the outermost sensor offsets to take into account the different behavior of SOI and bulk wafers. To adapt the sensor offsets, a number of SOI wafers, having the same device layer and oxide layer thicknesses, are used for different values of the sensor offsets and then the slip lines and/or wafer deformation are measured using standard techniques. Finally the sensor offset providing the best results is chosen.

This method, even being a direct way of calibrating, has nevertheless the drawback that to obtain a calibration, expensive SOI wafers are needed which will be scrapped at the end of the calibration. As thermal processing equipment needs to be regularly calibrated, as they suffer from continuous drift, the calibration method using SOI wafers becomes too costly to be employed on a regular basis. Finally, this second method is based on the ability to measure and identify slip lines and/or wafer deformation, which is a relatively cumbersome and thus not suitable to be carried out on a regular basis.

United States Patent nr. US 6,200,023 discloses a method for calibrating thermal processing equipment wherein a layer with a thickness profile (copper oxide coating) is formed on a test substrate by thermal processing. If the thickness profile of the copper oxide coating is non-uniform, the heater is adjusted to achieve greater temperature uniformity. Comparison with a calibration thickness profile is not mentioned.

It is therefore the object of this invention to provide a calibration method for calibrating thermal processing equipment to be used for heat treatment of a multilayer substrate with which the equipment parameters can be easily established without an excessive use of multilayer substrates.

This object is achieved with the method for calibrating thermal processing equipment comprising a heating device and which is used for heat treatment of a multilayer substrate according to claim 1.

The invention is based on the surprising effect that a predetermined thickness profile, also called "golden profile", of a layer thermally processed on a test substrate can be associated to each type of multilayer substrate. The test substrate has a different structure compared to the multilayer substrate and is usually cheaper than a multilayer substrate for which the thermal processing equipment is going to be calibrated. The golden profile corresponds to the layer thickness profile achieved across the diameter of a test substrate, wherein the test substrate has been processed by a thermal processing equipment which has been calibrated for the type of multilayer substrate in question, wherein during calibration either a layer with an even thickness profile has been achieved on the multilayer substrate, in case the equipment is to be used for forming layers on the multilayer substrate, or a multilayer substrate showing an reduced amount, in particular nearly no or no, slip lines and/or reduced wafer deformation is achieved compared to a mulitlayer processed in the non calibrated equipment, in case the equipment is to be used for smoothing purposes.

The predetermined thickness profile, also called golden profile in the following, can be obtained by any suitable technique known in the prior art, like for example ellipsometry.

Once the golden profile is established for a given multilayer substrate, the test substrate can be used anytime a new calibration of a thermal processing equipment needs to be carried out. In fact, to calibrate the thermal processing equipment, it is now sufficient to form a layer on a new test substrate, to measure the thickness profile achieved and to compare it with the corresponding golden profile. If differences are observed, the process parameters can then be amended such that the differences are taken into account. Knowing that the amended set of thermal process parameters will lead to a thickness profile on the test substrate corresponding to the golden profile, one is also ensured that on a corresponding multilayer substrate an even thickness profile or a multilayer substrate with reduced slip lines and/or reduced wafer deformation will be achieved with the amended set of thermal process parameters.

Compared to the prior art, it is thus possible to use cheaper test substrates for the calibration instead of the expensive multilayer substrates. In addition, one can use the properties of the thickness profile to adapt the heating device for which the correlation is easier to establish than for the heat absorption coefficients used in one of the prior art methods. Finally, the thickness profile measurement on the test substrate can be more easily carried out than the slip line and/or wafer deformation measurements, and are thus advantageous for a regular use.

In this context, test substrates and calibration test substrates refer to substrates with the same structure, but wherein the calibration test substrate is a test substrate that has been used to establish the predetermined thickness profile (golden profile) of the calibration layer which has been formed on the calibration test substrate using the same thermal process conditions for which an even thickness profile has been achieved for the layer formed on the multilayer substrate or for which reduced, in particular nearly no or no, slip lines and/or reduced wafer deformations have been observed. The term "thermal process parameters" relates to any parameter of the equipment susceptible to influence the heat profile in the equipment.

Preferably, the set of thermal process parameters of step B can correspond to the set of predetermined thermal process conditions. Usually drift alters the process conditions in a slow and steady way, so that the optimized thermal process parameters shall be close to the ones of the predetermined thermal process conditions.

According to a preferred embodiment the predetermined thickness profile can be obtained in a different thermal processing equipment. If in some equipment the golden profile corresponds to a flat thickness profile on a multilayer substrate after forming an additional layer on the multilayer substrate or to a multilayer substrate with reduced slip lines and/or reduced wafer deformation after smoothing, the same will also be true for a different equipment, as long as the same multilayer substrates are used. This means that essentially the golden profile only needs to be determined once for one type of equipment and can then be reused for all the other processing equipment used, which further reduces the costs for carrying out the calibration on the equipment.

According to a variant, a second test substrate can be provided and thermally processed according to the amended set of thermal process parameters after step d) to validate the calibration. To prevent that multilayer substrates are processed with a still not optimized calibration, it is preferable to verify the amendment to the thermal process parameters again with a further test substrate which is also thermally processed and the obtained thickness profile is then again compared to the golden profile to check whether the amendments have been carried out correctly. In case a difference is still present, the amendments to the thermal process parameters of the heating device can then still be fine tuned.

Preferably the heat device can comprise a plurality of heaters for locally heating the test substrate and a plurality of probes for locally measuring the temperature of the test substrate and wherein in step d) the heating power provided by each of the plurality of heaters is individually adapted. Actually to each probe a heater or a group of heaters can be attributed and depending on where in the thickness profile one observes differences with respect to the golden profile, the amendments to the heating device can be locally carried out.

Preferably the heating power of each heater can be individually adapted by individually amending the offset values of the plurality of probes. This is a relatively easy way to implement a localized adaption of the heating power provided to the substrate.

Advantageously the surface layer of the multilayer substrate and of the test substrate can be of the same material. In this case the physics and/or chemistry governing the layer formation are comparable such that the difference between the golden profile and the even profile on the multilayer substrate can be kept relatively small which makes the method more precise and further improves the calibration method.

Even more preferably, the surface layer of the multilayer substrate and the test substrate can have the same crystalline structure. As the crystalline structure plays an important role on the growth of an additional layer on it, comparable crystalline structures do also lead to the fact that the differences between the golden profile and even thickness profile can be kept to a minimum such that the difference between a calibration with a multilayer substrate and a calibration with a test substrate can actually be kept small.

According to an advantageous embodiment the multilayer substrate can be a silicon on insulator (SOI) type wafer and the test substrate a silicon wafer. Today silicon wafers are a standard high volume product which are readily available with good quality and relative low prices, whereas SOI wafers are still expensive substrates.

According to a variant, the heat treating can be a rapid thermal annealing treatment or a rapid thermal oxidation treatment. Due to the high temperatures used and the short processing times in these treatments, a calibrated processing equipment is crucial for the success of the application, as only small local differences in temperature can lead to a negative impact on the product to be treated. Thus, with the proposed cheap and easy to carry out calibration a high production yield can be achieved and this for film forming as well as smoothing purposes.

The new invention also relates to a method for creating a calibration thickness profile used for calibrating thermal processing equipment, in particular, used in the calibration method according to one of claims 1 to 10, wherein the thermal processing equipment comprises a heating device for heat treating a multilayer substrate according to claim 11.

This method is used to obtain the predetermined thickness profiles (golden profiles) which are advantageously employed in the calibration of thermal processing equipment as described above. The thickness profiles once obtained can be measured using the standard prior art techniques, like ellipsometry.

Preferably, the calibration thickness profile can be determined with a higher resolution at the edge of the calibration test substrate than in the center region of the calibration test substrate. As already explained above, the main differences between a multilayer substrate and a bulk type test substrate arise in the edge areas. It is therefore of interest to have more data available in this region to later on obtain a better calibration of the thermal processing equipment, especially for the critical edge region. Thus a better fine tuning of the thermal process parameters can be carried out, which is based on the higher amount of measurement points which can be compared to the golden profile.

Preferably the calibration thickness profile can be determined for a plurality of different multilayer substrates. Golden profiles should be determined for all sorts of multilayers, based on different materials and thicknesses of the various layers, so that for each product the optimum golden profile can be used for the calibration of the heating device of the thermal processing equipment. In addition, golden profiles can be determined for equipment used for forming additional layers and/or for equipment used for smoothing operations.

Preferably the calibration thickness profile(s) can be stored in a database. In this case anytime a thermal processing equipment needs to be calibrated for a given multilayer substrate, the operator or the equipment itself can choose the corresponding golden profile and carry out the calibration. This furthermore helps in reducing the time necessary to carry out the calibration, as at anytime the necessary data can be read out from the database.

Advantageously, the multilayer substrate is an SOI type wafer and the test substrate a silicon wafer. Today silicon wafers are a standard high volume product which are readily available with good quality and relative low prices, whereas SOI wafers are still expensive substrates.

Furthermore the invention relates to a calibration test substrate comprising a thermally formed layer on one of its main surfaces with a predetermined thickness profile according to claim 16. Using the predetermined thickness profile of this calibration test substrate, the advantageous calibration method as described above can be carried out.

Preferably the multilayer substrate can be an SOI type wafer and the test substrate a silicon wafer. Today silicon wafers are a standard high volume product which are readily available with good quality and relative low prices, whereas SOI wafers are still expensive substrates.

Specific embodiments of the present invention will become more apparent from the following detailed description with reference to the accompanying drawings wherein:
Fig. 1 - schematically shows a thermal processing equipment,
Fig. 2a - shows a multilayer substrate with a layer obtained by thermal processing and with an even thickness profile,
Fig. 2b - shows a test substrate with a predetermined thickness profile obtained under the same process conditions for which an even thickness profile has been achieved on the multilayer substrate of Fig. 2a,
Fig. 3a - illustrates a flow diagram illustrating a first embodiment of the method to determine the predetermined thickness profile (golden profile),
Figs. 3b and 3c - are illustrating the even thickness profile on a multilayer substrate and the corresponding predetermined thickness profile (golden profile) of the test substrate respectively,
Fig. 3d - illustrates a flow diagram illustrating a second embodiment of the method to determine the predetermined thickness profile,
Fig. 4a - shows a flow diagram illustrating the inventive calibration method, and
Fig. 4b - illustrates thickness profiles obtained on a test wafer compared to the golden profile illustrated in Fig. 3c.

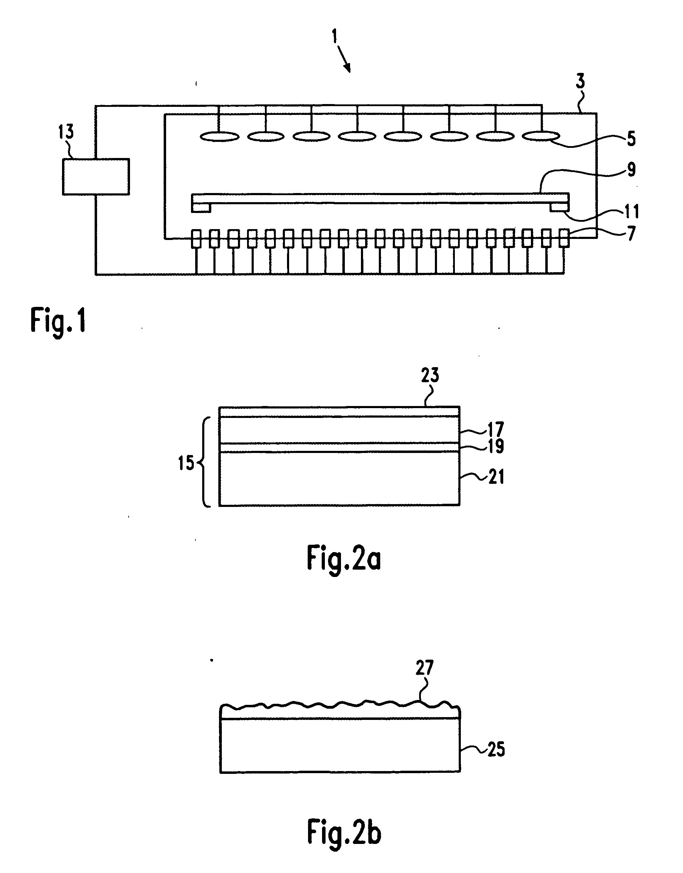

Fig. 1 illustrates a typical thermal processing equipment used in the semiconductor industry to heat treat substrates, in particular wafers, and which are used for forming layers or for annealing. In multilayer substrate fabrication they also play a role in surface smoothing.

The thermal processing equipment 1 illustrated can be of a vertical or horizontal thermal reactor type and can be either a batch or a single wafer type. The thermal processing equipment 1 comprises a furnace chamber 3 in which are arranged a plurality of heaters 5 building a heating device, a plurality of probes 7 for locally measuring the temperature of a substrate 9 which is positioned on a support means 11. As shown in Fig. 1, the amount of probes 7 does not necessarily have to be the same as the amount of individual heaters 5. Here more probes 7 than individual heaters 5 are indicated. The furnace 1 furthermore comprises a control unit 13 which based on the individual temperatures measured by the probes 7 is controlling the heat provided by the individual heaters 5.

For the use of the thermal processing equipment 1, it is essential that across the substrate 9 the heaters 5 provide a uniform temperature distribution, so that the layer growth or annealing carried out with the equipment is in turn also uniform or at least optimized. In this case, when used to form a layer over the substrate 9, the obtained layer will show an even thickness profile. For example, an oxide layer is obtained by providing an oxygen gas to the chamber. When used for smoothing purposes, which is achieved by switching form oxygen to hydrogen or argon, the substrate 9 will show a reduced amount of, in particular nearly no or no, slip lines and/or a reduced deformation.

Thermal processing equipment, like the one illustrated in Fig. 1 needs to be recalibrated from time to time, to correct for drifting properties. Under production conditions, such a calibration usually needs to be carried out at least once a week.

Fig. 2a illustrates a multilayer substrate 15, like for example, a silicon on insulator (SOI) type substrate with a device layer 17 on an oxide layer 19 which in turn is provided on a silicon substrate 21. This SOI substrate 15, however, only serves as an example as other multilayer structures, like for example strained silicon on insulator or germanium on insulator multilayer substrates may also be concerned. The multilayer substrate 15 has been heat treated in a thermal processing equipment 1 in an oxygen atmosphere, like described above with respect to Fig. 1, such that a layer 23, for instance an oxide layer, is formed on the multilayer substrate 15, namely on the device layer 17. When using a correctly calibrated thermal processing equipment, this layer 23 shows an even thickness profile over essentially the whole surface of the multilayer substrate 15.

Now Fig. 2b illustrates a test substrate 25, here a silicon (Si) wafer, on which, using the same thermal processing equipment 1 under the same thermal process parameters and in the calibrated state, also a layer 27 has been formed. Compared to layer 23 with an even thickness profile, this layer 25 shows a different thickness profile, like illustrated in Fig. 2b in an exaggerated manner. This is due to the fact that the bulk Si substrate 25 behaves differently from the multilayer substrate 15 with respect to the growth of the layers 27, 23, respectively. In the state of the art this difference has been attributed to local differences in heat absorption coefficients, like laid down in US 6,853,802.

As mentioned earlier, the thermal processing equipment 1 needs to be calibrated prior to the first use and then also from time to time. In the prior art this is done using a multilayer substrate 13 and growing an oxide layer on it, then measuring the thickness profile, and individually adapting the heaters 5 by, for example, changing the offsets of the corresponding probes. Another way was to identify the heat absorption coefficient locally and starting from there, adapting the heat provided locally. Now, according to the invention, use is made of a test substrate 25, different to the multilayer substrate, to calibrate the thermal processing equipment 1. Thus one does not need to use the more expensive multilayer substrates 13 any longer for calibration purposes.

This will now be explained in detail in the following for the case that a layer, like layer 23 in Fig. 2a, is formed on the multilayer substrate. The inventive calibration method is based on the idea that the thickness profile of layer 27 can be used to calibrate the thermal processing equipment 1, as when one achieves this thickness profile with a test substrate 25, it is ensured that one would achieve an even thickness profile on a multilayer substrate 13.

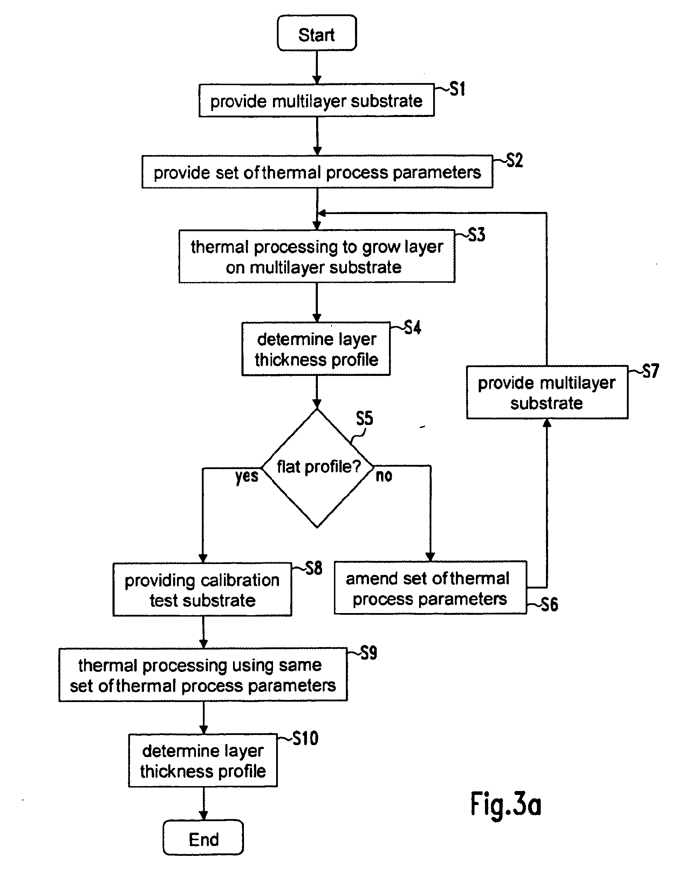

Fig. 3a illustrates one embodiment of a method for creating a calibration thickness profile used for the calibration of a thermal processing equipment according to the invention. Reference will be made to the equipment and substrates illustrated in Figs. 1, 2a and 2b. Their properties will not be repeated again but are incorporated by reference. However, other thermal processing equipment, like for instance an epitaxial deposition tool, and substrates could of course also be used.

In step S1 a multilayer substrate 15 is provided in thermal processing equipment 1 to be calibrated and is positioned on the support means 11. Then in step S2 a set of thermal process parameters is provided to the control unit 13. Then in step S3 an oxide layer is thermally formed on the multilayer substrate 15, for instance a layer of a thickness of about 100 Å. This is achieved by providing oxygen to the chamber 3.

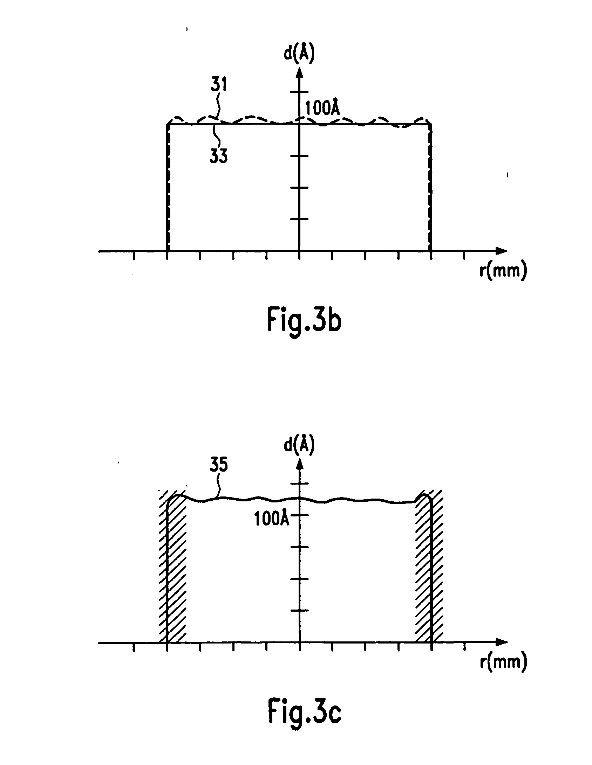

Then in step S4 the thickness profile of the thermally formed layer 23 is determined. This is done using standard thickness measurement methods, like for example ellipsometry. Fig. 3b illustrates such a thickness profile 31 in a non-calibrated state in dotted lines. In Fig. 3b the thickness d (measured in A) is plotted on the y-axis, whereas on the x-axis the distance to the center of the multilayer substrate 15 is plotted. Actually the thickness over the diameter of the multilayer 15 is shown, but of course also a two-dimensional thickness profile could be established. As can be seen from Fig. 3b, in the non-calibrated state, the thickness varies around a width value of 100 Å, which is an indication that the heat distribution is not even.

In step S5 it is checked whether a flat profile has been achieved or not. When obtaining the uneven thickness profile 31 (dotted line in Fig. 3b) the decision taken is "no" and as a consequence the process continues with step S6, wherein the set of thermal process parameters in the control unit 13 is amended. For positions where the thickness is higher than 100 Å, the corresponding heaters 5 have to provide less heating power, which can for example be realized by changing the offset of the probes, and at positions where the thickness is lower than 100 Å, more heating power is necessary which needs to be provided by the corresponding heaters 5.

In step S7 a new multilayer substrate 15 is provided in the thermal processing equipment 1 and the steps S3 and S4 are repeated, now with the amended set of thermal process parameters. In fact, the steps S3 to S7 are repeated until in step S5 a flat thickness profile 33 is observed. Such a flat or even thickness profile 33 on a multilayer substrate 15 is illustrated in Fig. 3b with a solid line. Now in this case the thermal processing equipment 1 is in a calibrated state.

In step S8 a test substrate 25, in the following called calibration test substrate, is provided and positioned in the calibrated thermal processing equipment 1. Then (step S9) a layer 27 is formed on the calibration test wafer 25 using the set of thermal process parameters for which the even thickness profile 33 has been achieved on the multilayer substrate 15, like illustrated in Fig. 3b (solid line).

Then in step S10 the thickness profile of the layer 27 formed on the calibration test substrate 25 is determined in the same way as the layer formed on the multilayer substrate 15. The corresponding thickness profile 35 is illustrated in Fig. 3c wherein again the measured thickness is plotted on the y-axis and the distance to the center of the calibration test substrate 25 is plotted on the x-axis. As can be seen from Fig. 3c for the same thermal process parameters, with which an even thickness profile 33 has been achieved on a multilayer substrate 15, a different thickness profile 35 is now achieved on the calibration test substrate 25. This is due to the differences in the heat absorption coefficients between the two substrates which in turn is due to the different structure between the test substrate 25 and the multilayer substrate.

Now this profile 35 will be used in the following as a calibration thickness profile, here also called golden profile or predetermined thickness profile, when recalibrating a thermal processing equipment. As the main difference between the thickness profile 35 shown in Fig. 3c and the even thickness distribution 33 shown in Fig. 3b are found in the edge region (shaded part of Fig. 3c) it is advantageous to measure the thickness profile with a higher resolution in this edge region of the calibration test substrate.

The measured golden profile 35 can then be stored in a database such that it is easily transferable from one thermal processing equipment to another. Furthermore this database may comprise golden profiles for different types of multilayer substrates. In particular golden profiles for device layers 17 of different materials and thicknesses, for oxide layers 19 of different thicknesses and for different base substrates 21.

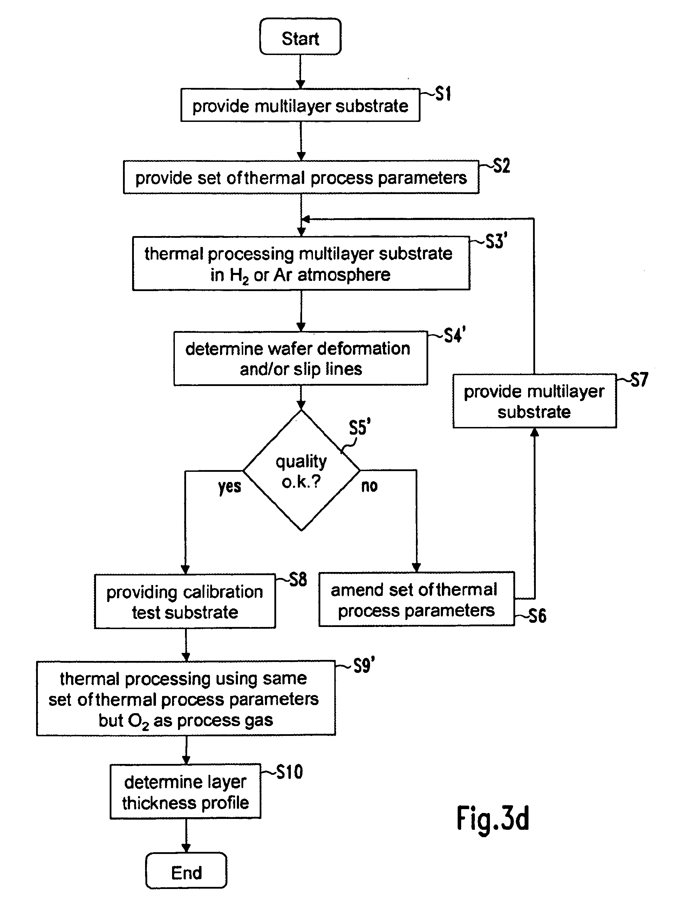

Fig. 3d illustrates a second embodiment of the method for creating a calibration thickness profile used for the calibration of a thermal processing equipment according to the invention. In fact, when the thermal equipment is used for smoothing purposes, process steps S3, S4, S5 and S9 are amended with respect to the corresponding process steps in the first embodiment. The other steps are the same as in the first embodiment and their description is not repeated again but incorporated by reference.

Instead of providing oxygen to the furnace chamber 3 in this embodiment hydrogen (H₂) or argon (Ar) is provided and thus a surface smoothing step is carried out in step S3'. In SOI substrate production this step is for example carried out to improve the surface quality of the product. As, however, thermal non-uniformities, present in a non-calibrated equipment, lead to the formation of slip lines and/or wafer deformation, a calibration also is necessary. Therefore in Step S4' the multilayer substrate is analyzed to measure wafer deformation and slip line formation. This is done using standard methods. Then in step S5' it is checked whether the results are sufficiently good to ensure the necessary product quality, in particular, whether the number of slip lines is reduced and/or whether an reduced wafer deformation is observed compared to what is obtained in an uncalibrated equipment, in which slip lines and/or wafer deformation occur due to thermal non-uniformities. If this is the case the process continues with step S8, wherein during step S9' the gas supply is switched back to oxygen (O₂) to form an oxide layer on the test substrate. If this is not the case the process continues with step S6, like described above.

Slip lines are typically measured using inspection tools. The measurement is expressed in total millimeter over the substrate (wafer). It is the aim of the calibration according to this embodiment to achieve a minimized amount of slip lines, in particular zero slip lines.

Wafer deformation is typically measured by warp and bow measurements and, if wafer deformation is considered during calibration, it is again the aim to optimize the calibration by minimizing the deformation (expressed in µm) or to even achieve zero deformation.

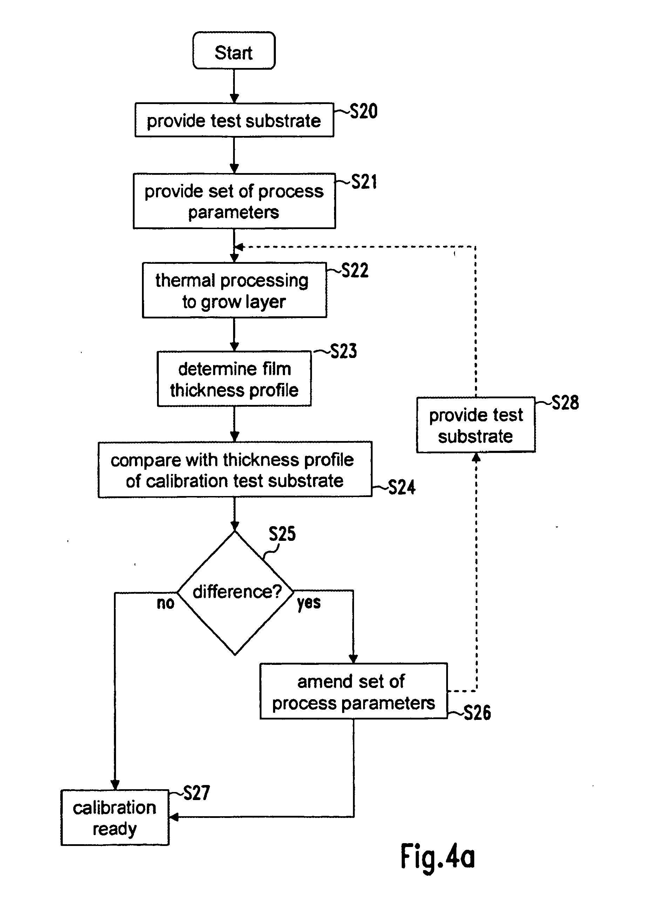

Fig. 4a illustrates an embodiment of a method for calibrating thermal processing equipment according to the invention. Again reference will be made to the thermal processing equipment 1, the multilayer substrate 15 and the test substrate 25 as shown in Figs. 1, 2a and 2b. Their properties will not be repeated again but are incorporated by reference. However, other thermal processing equipment and substrates could of course also be used.

The inventive calibration method takes advantage of the golden profile 35 as achieved by the above-described process (see Figs. 3a to 3c). In step S20 a test substrate 25 is provided in the thermal processing equipment 1 which can be the same or another thermal processing equipment as the one in which the golden profile 35 on the calibration test substrate has been achieved. Then in step 21 a set of thermal process parameters is provided to the control unit 13 of the thermal processing equipment 1 which is used to control the heating device with the plurality of heaters 5. In a variant, the set of thermal process parameters can be the set of thermal process parameters for which the golden profile has been achieved in the method for creating a calibration thickness profile as described above with respect to Fig. 3a. This of course is only possible in case the thermal processing equipment to be calibrated is of the same type as the one in which the golden profile has been obtained.

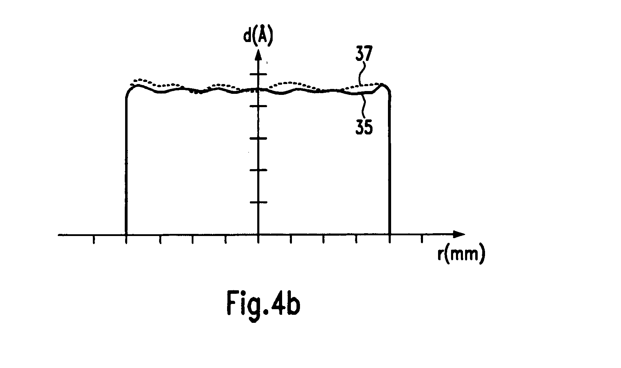

In step S22 the test substrate 15 is then thermally processed to form a layer thereon. Then in step S23 the thickness profile of the layer is determined using standard thickness measurements, like ellipsometry. The corresponding thickness profile 37 is illustrated in Fig. 4b, where the thickness of the layer is plotted on the y-axis, whereas the distance with respect to the center of the test substrate 15 is plotted on the x-axis. The determined thickness profile 37 is traced in dotted lines on Fig. 4b. The corresponding golden profile 35 is plotted with a continuous line and corresponds to the one already traced in Fig. 3c. From the difference in the two profiles it can be concluded that the thermal processing equipment needs a recalibration. In fact, only in case the dotted thickness profile 37 of the layer on the test substrate and the predetermined thickness profile 35 with the solid line of a calibration layer on a calibration test substrate correspond to each other, an even thickness profile 33 can be achieved on a multilayer substrate with the thermal processing equipment, or according to the variant a multilayer substrate with an reduced amount of, in particular nearly no or no, slip lines and/or a reduced wafer deformation.

In step S25 it is decided whether the thickness profiles correspond to each other or not. If a difference is observed the method for calibrating the thermal processing equipment continues with step S26. This step consists in amending the set of thermal process parameters such that the heating device is adapted to compensate the differences observed between the thickness profile 37 and the predetermined thickness profile 35 of the calibration layer. Once this is done, the calibration is ready (step S27) and the process for calibrating comes to an end. If the two profiles 35, 37, however, correspond to each other the calibration immediately ends as no recalibration is necessary.

According to a variant, it is also possible to provide an additional test substrate in case one has amended the set of thermal process parameters (step S28) and steps S22 to S24 are carried out again to verify that, indeed, the amended thermal process parameters are such that a thickness profile corresponding to the golden profile is obtained on the addition test substrate.

The adapting of the thermal process parameters is carried out by changing the heating power provided by the heaters 5 of the heating device of the thermal processing equipment 1. In fact, each heater 5 can be controlled individually such that a local adapting can be realized. Changing the heating power can be done be directly influencing the heaters or by changing the offset of the corresponding probes 7 measuring the temperature on the substrate.

In the figures the method for calibrating the thermal processing equipment 1 and the method for creating a calibration thickness profile have been explained using a SOI multilayer substrate and a Si wafer as a test substrate 25. However, the present invention is not limited to this material choice but other multilayer substrates or test substrates can be used in the same way. In this case also it is advantageous to carry out the calibrating with a test substrate having the same material as the surface layer of the multilayer substrate or to have a test substrate with the same crystalline structure as the surface layer of the multilayer substrate. In cases where a bulk substrate is not available or comparatively expensive, still a low cost Si wafer could be used as test substrate.

The disclosed method for calibrating a thermal processing equipment and for creating a calibration thickness profile are of particular interest when the thermal processing equipment is used for rapid thermal annealing treatments, e.g. in Hydrogen (H) or Argon or a mixture of H and Ar atmosphere, or rapid thermal oxidation treatments. For those treatments a well calibrated equipment is necessary as high temperatures are involved and only small deviations from an even temperature distribution can have an impact on the quality of the layers formed or annealed.

Finally, the test substrate 25 with the layer 27 having the golden profile, as shown in Fig. 2b, represents one embodiment of a calibration test substrate according to this invention, as the thermally formed layer thereon is obtained with the set of thermal process parameters for which a layer 23 with an even thickness profile has been achieved on the multilayer substrate 15 shown in Fig. 2a.

## Claims

1. Method for calibrating a thermal processing equipment (1) comprising a heating device (5) and which is used for a heat treatment of a multilayer substrate (15) **characterized in**
comprising the steps:
a) providing a test substrate (25) with a different structure compared to the multilayer substrate (15),
b) thermal processing of the test substrate (25) using a set of thermal process parameters to thereby form a layer (27) on the test substrate (25) with a thickness profile (37),
c) comparing the thickness profile (37) with a predetermined thickness profile (35) of a calibration layer on a calibration test substrate, and
d) amending the set of thermal process parameters such that the heating device (5) is adapted to compensate the differences between the thickness profile (37) and the predetermined thickness profile (35),
wherein the predetermined thickness profile (35) of the calibration layer on the calibration test substrate corresponds to an even thickness profile (33) of a layer (23) on a multilayer substrate (15) or to a multilayer substrate (15) for which reduced slip lines and/or reduced deformation have been observed, when treated with the same set of predetermined thermal process conditions.

2. Method according to claim 1, wherein the set of thermal process parameters of step b) corresponds to the set of thermal predetermined process conditions.

3. Method according to claim 1 or 2, wherein the predetermined thickness profile (35) has been obtained in a different thermal processing equipment (1).

4. Method according to one of claims 1 to 3, wherein after step d) a second test substrate is provided and thermally processed according to the amended set of thermal process parameters to validate the calibration.

5. Method according to one of claims 1 to 4, wherein the heat device comprises a plurality of heaters (5) for locally heating the test substrate (25) and a plurality of probes (7) for locally measuring the temperature of the test substrate (25) and wherein in step d) the heating power provided by each of the plurality of heaters (5) is individually adapted.

6. Method according to claim 5, wherein the heating power of each heater (5) is individually adapted by individually amending the offset values of the plurality of probes (7).

7. Method according to one of claims 1 to 6, wherein the surface layer (17) of the multilayer substrate (15) and the test substrate (25) are of the same material.

8. Method according to one of claims 1 to 7, wherein the surface layer (17) of the multilayer substrate (15) and the test substrate (25) have the same crystalline structure.

9. Method according to one of claims 1 to 8, wherein the multilayer substrate (15) is a Silicon on insulator (SOI) type wafer and the test substrate (25) a Silicon wafer.

10. Method according to one of claims 1 to 9, wherein the heat treating is a rapid thermal annealing treatment or rapid thermal oxidation treatment.

11. Method for creating a calibration thickness profile used for calibrating a thermal processing equipment (1), in particular used in a calibration method according to one of claims 1 to 10, wherein the thermal processing equipment (1) comprises a heating device (5) for heat treating a multilayer substrate (15) comprising the steps:
a) calibrating the heating device (5) such that during thermal processing a layer (23) with an even thickness profile (33) is formed on a multilayer substrate (15) or a multilayer substrate (15) with reduced slip lines and/or reduced deformation is obtained ,
b) identifying the corresponding set of thermal process parameters,
c) providing a calibration test substrate (25) with a different structure compared to the multilayer substrate (15),
d) thermal processing of the calibration test substrate (25) using the corresponding set of thermal process parameters to thereby form a layer (27) on the calibration test substrate (25) with a calibration thickness profile (35), and
e) determining the calibration thickness profile (35).

12. Method according to claim 11, wherein in step e) the calibration thickness profile (35) is determined with a higher resolution at the edge of the calibration test substrate (25) than in the center region of the calibration test substrate (25).

13. Method according to claim 11 or 12, wherein the calibration thickness profile (35) is determined for a plurality of different multilayer substrates (15).

14. Method according to one of claims 11 to 13, further comprising the step of storing the calibration thickness profile(s) (35) in a database.

15. Method according to one of claims 11 to 14, wherein the multilayer substrate (15) is a SOI type wafer and the test substrate (25) a Si wafer.

16. Calibration test substrate comprising a layer (27) thermally formed on one of its main surfaces with a predetermined thickness profile (35) **characterized in that** the thermally formed layer (27) is obtained with a set of thermal process parameters for which a layer (23) with an even thickness profile (33) is achieved on a multilayer substrate (15) or a multilayer substrate with reduced slip lines and/or reduced deformation is obtained.

17. Calibration test substrate according to claim 16, wherein the multilayer substrate (15) is a SOI type wafer and the test substrate (25) a Si wafer.

## Patentansprüche

1. Verfahren zum Kalibrieren einer Wärmebearbeitungseinrichtung (1), die eine Erwärmungseinrichtung (5) umfasst und die für eine Wärmebehandlung eines mehrschichtigen Substrats (15) eingesetzt wird, **dadurch gekennzeichnet, dass** es die folgenden Schritte umfasst:
a) Bereitstellen eines Test-Substrats (25), das einen anderen Aufbau hat als das mehrschichtige Substrat (15),
b) Wärmebearbeitung des Test-Substrats (25) unter Verwendung einer Gruppe von Wärmebearbeitungsparametern, um so eine Schicht (27) auf dem Test-Substrat (25) mit einem Dickenprofil (37) auszubilden,
c) Vergleichen des Dickenprofils (37) mit einem vorgegebenen Dickenprofil (35) einer Kalibrierungsschicht auf einem Kalibrierungs-Testsubstrat, und
d) Ändern der Gruppe von Wärmebearbeitungsparametern so, dass die Erwärmungseinrichtung (5) so eingerichtet ist, dass sie die Unterschiede zwischen dem Dickenprofil (37) und dem vorgegebenen Dickenprofil (35) ausgleicht,
wobei das vorgegebene Dickenprofil (35) der Kalibrierungsschicht auf dem Kalibrierungs-Testsubstrat einem gleichmäßigen Dickenprofil (33) einer Schicht (23) auf einem mehrschichtigen Substrat (15) oder einem mehrschichtigen Substrat (15) entspricht, für das verringerte Gleitlinien und/oder verringerte Verformung bei Behandlung mit der gleichen Gruppe vorgegebener Wärmebearbeitungsbedingungen beobachtet worden sind.

2. Verfahren nach Anspruch 1, wobei die Gruppe von Wärmebearbeitungsparametern von Schritt b) der Gruppe vorgegebener Wärmebearbeitungsbedingungen entspricht.

3. Verfahren nach Anspruch 1 oder 2, wobei das vorgegebene Dickenprofil (35) in einer anderen Wärmebehandlungsanlage (1) erzielt worden ist.

4. Verfahren nach einem der Ansprüche 1 bis 3, wobei nach Schritt d) ein zweites Test-substrat bereitgestellt und entsprechend der geänderten Gruppe von Wärmebearbeitungsparametem wärmebearbeitet wird, um die Kalibrierung zu validieren.

5. Verfahren nach einem der Ansprüche 1 bis 4, wobei die Erwärmungseinrichtung eine Vielzahl von Heizeinrichtungen (5) zum lokalen Erhitzen des Testsubstrats (25) und eine Vielzahl von Sonden (7) zum lokalen Messen der Temperatur des Testsubstrats (25) umfasst, und wobei in Schritt d) die Erwärmungsenergie, die durch jede der Vielzahl von Heizeinrichtungen (5) bereitgestellt wird, individuell angepasst wird.

6. Verfahren nach Anspruch 5, wobei die Erwärmungsenergie jeder der Heizeinrichtungen (5) individuell angepasst wird, indem individuell die Offset-Werte der Vielzahl von Sonden (7) geändert werden.

7. Verfahren nach einem der Ansprüche 1 bis 6, wobei die Oberflächenschicht (17) des mehrschichtigen Substrats(15) und des Testsubstrats (25) aus dem gleichen Material bestehen.

8. Verfahren nach einem der Ansprüche1 bis 7, wobei die Oberflächenschicht (17) des mehrschichtigen Substrats (15) und des Testsubstrats (25) die gleiche Kristallstruktur haben.

9. Verfahren nach einem der Ansprüche 1 bis 8, wobei das mehrschichtige Substrat (15) ein SOI-Wafer (Silicon on insulator type wafer) ist und das Testsubstrat (25) ein Silizium-Wafer ist.

10. Verfahren nach einem der Ansprüche 1 bis 9, wobei die Wärmebehandlung eine schnelle thermische Ausheilbehandlung oder eine schnelle thermische Oxidationsbehandlung ist.

11. Verfahren zum Erzeugen eines Kalibrierungs-Dickenprofils, das zum Kalibrieren einer Wärmebearbeitungsanlage (1) eingesetzt wird, insbesondere bei einem Kalibrierungsverfahren nach einem der Ansprüche 1 bis 10 eingesetzt wird, wobei die Wärmebehandlungsanlage (1) eine Erwärmungseinrichtung (5) zur Wärmebehandlung eines mehrschichtigen Substrats (15) umfasst, und das Verfahren die folgenden Schritte umfasst:
a) Kalibrieren der Erwärmungseinrichtung (5), so dass bei Wärmebearbeitung eine Schicht (23) mit einem gleichmäßigen Dickenprofil (33) auf einem mehrschichtigen Substrat (15) ausgebildet wird oder ein mehrschichtiges Substrat (15) mit verringerten Gleitlinien und/oder verringerter Verformung gewonnen wird,
b) Identifizieren der entsprechenden Gruppe von Wärmebearbeitungsparametem,
c) Bereitstellen eines Kalibrierungs-Testsubstrats (25) mit einem anderen Aufbau als der des mehrschichtigen Substrats (15),
d) Wärmebearbeitung des Kalibrierungs-Testsubstrats (25) unter Verwendung der entsprechenden Gruppe von Wärmebearbeitungsparametern, um so eine Schicht (27) auf dem Kalibrierungs-Testsubstrat (25) mit einem Kalibrierungs-Dickenprofil (25) auszubilden, und
e) Bestimmen des Kalibrierungs-Dickenprofils (35).

12. Verfahren nach Anspruch 11, wobei in Schritt e) das Kalibrierungs-Dickenprofil (35) mit einer höheren Auflösung am Rand des Kalibrierungs-Testsubstrats (25) als in einem Mittelbereich des Kalibrierungs-Testsubstrats (25) bestimmt wird.

13. Verfahren nach Anspruch 11 oder 12, wobei das Kalibrierungs-Dickenprofil (35) für eine Vielzahl verschiedener mehrschichtiger Substrate (15) bestimmt wird.

14. Verfahren nach einem der Ansprüche 11 bis 13, das des Weiteren den Schritt des Speichems des/der Kalibrierungs-Dickenprofils/Dickenprofile (35) in einer Datenbank umfasst.

15. Verfahren nach einem der Ansprüche 11 bis 14, wobei das mehrschichtige Substrat (15) ein SOI-Wafer ist und das Testsubstrat (25) ein Si-Wafer ist.

16. Kalibrierungs-Testsubstrat, das eine Schicht (27) umfasst, die thermisch auf einer seiner Hauptflächen mit einem vorgegebenen Dickenprofil (35) ausgebildet wird, **dadurch gekennzeichnet, dass** die thermisch ausgebildete Schicht (27) mit einer Gruppe von Wärmebearbeitungsparametem gewonnen wird, für die eine Schicht (23) mit einem gleichmäßigen Dickenprofil (33) auf einem mehrschichtigen Substrat (15) erzielt wird, oder ein mehrschichtiges Substrat mit verringerten Gleitlinien und/oder verringerter Verformung gewonnen wird.

17. Kalibrierungs-Testsubstrat nach Anspruch 16, wobei das mehrschichtige Substrat (15) ein SOI-Wafer ist und das Testsubstrat (25) ein Si-Wafer ist.

## Revendications

1. Procédé pour étalonner un équipement de traitement thermique (1) comprenant un dispositif de chauffage (5) et qui est utilisé pour un traitement thermique d'un substrat à plusieurs couches (15), **caractérisé en ce qu'**il comprend les étapes consistant à :
a) fournir un substrat d'essai (25) avec une structure différente par rapport au substrat à plusieurs couches (15),
b) traiter thermiquement le substrat d'essai (25) en utilisant un ensemble de paramètres de procédé thermique pour former ainsi une couche (27) sur le substrat d'essai (25) avec un profil d'épaisseur (37),
c) comparer le profil d'épaisseur (37) avec un profil d'épaisseur prédéterminé (35) d'une couche d'étalonnage sur un substrat d'essai d'étalonnage, et
d) modifier l'ensemble des paramètres de procédé thermique de sorte que le dispositif de chauffage (5) est adapté pour compenser les différences entre le profil d'épaisseur (37) et le profil d'épaisseur prédéterminé (35),
dans lequel le profil d'épaisseur prédéterminé (35) de la couche d'étalonnage sur le substrat d'essai d'étalonnage correspond à un profil d'épaisseur régulier (33) d'une couche (23) sur un substrat à plusieurs couches (15) ou à un substrat à plusieurs couches (15) pour lequel des lignes de glissement réduites et/ou une déformation réduite ont été observées, lorsqu'il est traité avec le même ensemble de conditions de procédé thermique prédéterminées.

2. Procédé selon la revendication 1, dans lequel l'ensemble des paramètres de procédé thermique de l'étape b) correspond à l'ensemble des conditions de procédé thermique prédéterminées.

3. Procédé selon la revendication 1 ou 2, dans lequel le profil d'épaisseur prédéterminé (35) a été obtenu dans un équipement de traitement thermique différent (1).

4. Procédé selon l'une quelconque des revendications 1 à 3, dans lequel après l'étape d), on fournit un second substrat d'essai et il est traité thermiquement selon l'ensemble modifié des paramètres de procédé thermique pour valider l'étalonnage.

5. Procédé selon l'une quelconque des revendications 1 à 4, dans lequel le dispositif de chauffage comprend une pluralité d'éléments de chauffage (5) pour chauffer localement le substrat d'essai (25) et une pluralité de sondes (7) pour mesurer localement la température du substrat d'essai (25) et dans lequel, à l'étape d), la puissance de chauffage fournie par chacun de la pluralité d'éléments de chauffage (5) est adaptée individuellement.

6. Procédé selon la revendication 5, dans lequel la puissance de chauffage de chaque élément de chauffage (5) est adaptée individuellement en modifiant individuellement les valeurs décalées de la pluralité de sondes (7).

7. Procédé selon l'une quelconque des revendications 1 à 6, dans lequel la couche de surface (17) du substrat à plusieurs couches (15) et le substrat d'essai (25) sont réalisés avec le même matériau.

8. Procédé selon l'une quelconque des revendications 1 à 7, dans lequel la couche de surface (17) du substrat à plusieurs couches (15) et le substrat d'essai (25) ont la même structure cristalline.

9. Procédé selon l'une quelconque des revendications 1 à 8, dans lequel le substrat à plusieurs couches (15) est une plaquette de type silicium sur isolant (SOI) et le substrat d'essai (25) est une plaquette de silicium.

10. Procédé selon l'une quelconque des revendications 1 à 9, dans lequel le traitement thermique est un traitement de recuit thermique rapide ou un traitement d'oxydation thermique rapide.

11. Procédé pour créer un profil d'épaisseur d'étalonnage utilisé pour étalonner un équipement de traitement thermique (1), en particulier utilisé dans un procédé d'étalonnage selon l'une quelconque des revendications 1 à 10, dans lequel l'équipement de traitement thermique (1) comprend un dispositif de chauffage (5) pour traiter thermiquement un substrat à plusieurs couches (15), comprenant les étapes consistant à :
a) étalonner le dispositif de chauffage (5) de sorte que pendant le traitement thermique, une couche (23) avec un profil d'épaisseur régulière (33) est formée sur le substrat à plusieurs couches (15) ou un substrat à plusieurs couches (15) avec des lignes de glissement réduites et/ou une déformation réduite est obtenu,
b) identifier l'ensemble correspondant de paramètres de procédé thermique,
c) fournir un substrat d'essai d'étalonnage (25) avec une structure différente par rapport au substrat à plusieurs couches (15),
d) traiter thermiquement le substrat d'essai d'étalonnage (25) en utilisant l'ensemble correspondant des paramètres de traitement thermique pour former ainsi une couche (27) sur le substrat d'essai d'étalonnage (25) avec un profil d'épaisseur d'étalonnage (35), et
e) déterminer le profil d'épaisseur d'étalonnage (35).

12. Procédé selon la revendication 11, dans lequel à l'étape e), on détermine le profil d'épaisseur d'étalonnage (35) avec une résolution supérieure au niveau du bord du substrat d'essai d'étalonnage (25) que dans la région centrale du substrat d'essai d'étalonnage (25).

13. Procédé selon la revendication 11 ou 12, dans lequel le profil d'épaisseur d'étalonnage (35) est déterminé pour une pluralité de substrats à plusieurs couches (15) différentes.

14. Procédé selon l'une quelconque des revendications 11 à 13, comprenant en outre l'étape consistant à stocker le (les) profil(s) d'épaisseur d'étalonnage (35) dans une base de données.

15. Procédé selon l'une quelconque des revendications 11 à 14, dans lequel le substrat à plusieurs couches est une plaquette de type SOI et le substrat d'essai (25) est une plaquette Si.

16. Substrat d'essai d'étalonnage comprenant une couche (27) formée thermiquement sur l'une de ses surfaces principales avec un profil d'épaisseur prédéterminé (35), **caractérisé en ce que** la couche formée thermiquement (27) est obtenue avec un ensemble de paramètres de procédé thermique pour lesquels une couche (23) avec un profil d'épaisseur régulière (33) est obtenue sur un substrat à plusieurs couches (15) ou un substrat à plusieurs couches avec des lignes de glissement réduites et/ou une déformation réduite est obtenu.

17. Substrat d'essai d'étalonnage selon la revendication 16, dans lequel le substrat à plusieurs couches (15) est une plaquette de type SOI et le substrat d'essai (25) est une plaquette Si.
